(19) Europäisches Patentamt
European Patent Office
Office européen des brevets

(11) **EP 3 503 385 B1**

(12) **FASCICULE DE BREVET EUROPEEN**

(45) Date de publication et mention de la délivrance du brevet:
**05.04.2023 Bulletin 2023/14**

(21) Numéro de dépôt: **18212638.3**

(22) Date de dépôt: **14.12.2018**

(51) Classification Internationale des Brevets (IPC):
**H03F 1/32** $^{(2006.01)}$ **H03F 3/24** $^{(2006.01)}$

(52) Classification Coopérative des Brevets (CPC):
**H03F 3/245; H03F 1/3247; H03F 1/3258**

(54) **SYNCHRONISATION TEMPORELLE À FAIBLE COMPLEXITÉ DANS UNE BOUCLE DE CALCUL DE PRÉDISTORSION NUMÉRIQUE**

ZEITLICHE SYNCHRONISIERUNG MIT SCHWACHER KOMPLEXITÄT IN EINER BERECHNUNGSSCHLEIFE MIT DIGITALER VORVERZERRUNG

LOW-COMPLEXITY TIME SYNCHRONISATION IN A LOOP FOR CALCULATING DIGITAL PREDISTORTION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.12.2017 FR 1701347**

(43) Date de publication de la demande:
**26.06.2019 Bulletin 2019/26**

(73) Titulaire: **Thales**
**92400 Courbevoie (FR)**

(72) Inventeurs:
• **BERNIER, Jean-Yves**
**92230 GENNEVILLIERS (FR)**
• **TRAVERSO, Sylvain**
**92230 GENNEVILLIERS (FR)**
• **ROGIER, Jean-Luc**
**92230 GENNEVILLIERS (FR)**
• **JOLEC, François**
**92230 GENNEVILLIERS (FR)**

(74) Mandataire: **Atout PI Laplace**
**Immeuble "Visium"**
**22, avenue Aristide Briand**
**94117 Arcueil Cedex (FR)**

(56) Documents cités:
EP-A1- 1 331 729 EP-A1- 2 947 833
WO-A1-2011/058197 FR-A1- 2 769 152

**Description**

L'invention se situe dans le domaine des communications en général, qu'il s'agisse de communications filaires ou de radio communications, dès lors que le signal à émettre doit être amplifié par un amplificateur non linéaire dont les non linéarités sont compensées par un mécanisme de prédistorsion numérique.

Afin de respecter le bilan de liaison requis pour une communication, il est nécessaire d'amplifier le signal à transmettre. Cette amplification se fait généralement à l'aide d'un amplificateur de puissance analogique. Il existe un compromis dans le design ou le choix d'un amplificateur de puissance appelé compromis rendement/linéarité : plus la linéarité d'un amplificateur est importante, moins le rendement en puissance de cet amplificateur est bon, et inversement. En d'autres termes, plus l'amplificateur est linéaire, plus il consomme de puissance.

D'autre part, il existe deux grandes familles de signaux à transmettre :

- Les signaux dits à enveloppe constante. Ces signaux ont la propriété d'avoir une puissance instantanée constante en fonction du temps. Pour ce type de signaux, il est d'usage d'utiliser des amplificateurs à très fort rendements dont la faible linéarité ne perturbe pas le spectre du signal en sortie d'amplificateur.

- Les signaux dits à enveloppe non-constante. Ces signaux ont la propriété d'avoir une variation plus ou moins importante de la puissance instantanée en fonction du temps. Pour ces types de signaux, la linéarité de l'étape d'amplification est déterminante car elle impacte grandement le spectre du signal en sortie d'amplificateur. En effet, le signal à la sortie de l'amplificateur de puissance doit en général respecter un gabarit spectral plus ou moins contraignant, de façon à ne pas brouiller les canaux non utilisés par la transmission. Il est alors habituellement nécessaire d'utiliser des amplificateurs de puissance très linéaires dont le rendement est mauvais.

Pour réduire les remontées de spectre liées aux non linéarités de l'amplificateur de puissance, en particulier lors de la transmission de signaux à enveloppe non-constante, il est connu de modifier le signal modulé à transmettre de manière à pré-compenser les déformations appliquées par l'amplificateur de puissance. Ce procédé est connu sous le nom de linéarisation par prédistorsion. Cette prédistorsion peut être analogique ou numérique. L'invention se place dans le cadre de la prédistorsion numérique. La prédistorsion consiste à appliquer une non-linéarité en amont de l'amplificateur de puissance de manière à ce que l'association de la non-linéarité de la linéarisation avec l'amplificateur de puissance corresponde à un système linéaire. Il est ainsi possible d'utiliser un amplificateur de puissance ayant un meilleur rendement, tout en tolérant la non-linéarité associée car celle-ci est supposée être pré-compensée par le procédé de linéarisation. Il existe de nombreux algorithmes de prédistorsion numérique, plus ou moins complexes et plus ou moins performants. L'un d'eux, nommé GMP (acronyme anglais de Generalized Memory Polynomial), est décrit en détails dans l'article D.R. Morgan, Z. Ma, J. Kim, M. G. Zierdt et J. Pastalan, « A Generalized Memory Polynomial Model for Digital Predistortion of RF Power Amplifiers », IEEE Transactions on Signal Processing, vol. 54, no. 10, pp. 3852-3860, Oct. 2006.

Le procédé de linéarisation par prédistorsion numérique nécessite la connaissance du comportement de l'amplificateur de puissance. Cette connaissance est en général obtenue en disposant des versions bande de base des signaux aux entrée/sortie de l'amplificateur de puissance.

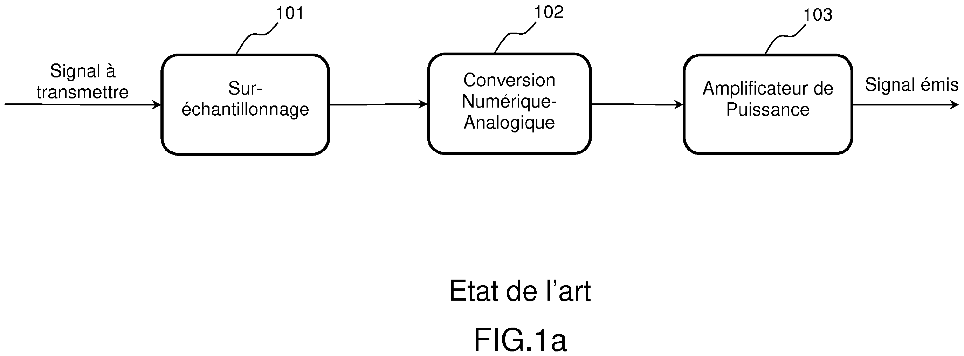

La figure 1a décrit les principaux éléments d'un équipement de transmission selon l'état de l'art ne mettant pas en oeuvre de prédistorsion.

Dans la figure 1a, le signal numérisé et modulé à transmettre est sur-échantillonné 101 puis converti en signal analogique par un convertisseur numérique-analogique (ou CNA) 102 et amplifié par un amplificateur de puissance 103 avant d'être émis. La figure 1a, tout comme les autres figures, ne représente pas les étapes bien connues de l'homme du métier et non nécessaires à la compréhension de l'invention que sont par exemple la transposition du signal analogique sur fréquence porteuse, ou les différentes étapes de filtrage du signal analogique, d'amplification successives ou d'atténuation lorsque c'est le cas.

Ce sont les non-linéarités de l'amplificateur 103 qui altèrent le signal à transmettre et viennent créer des remontées de spectre dans le signal émis.

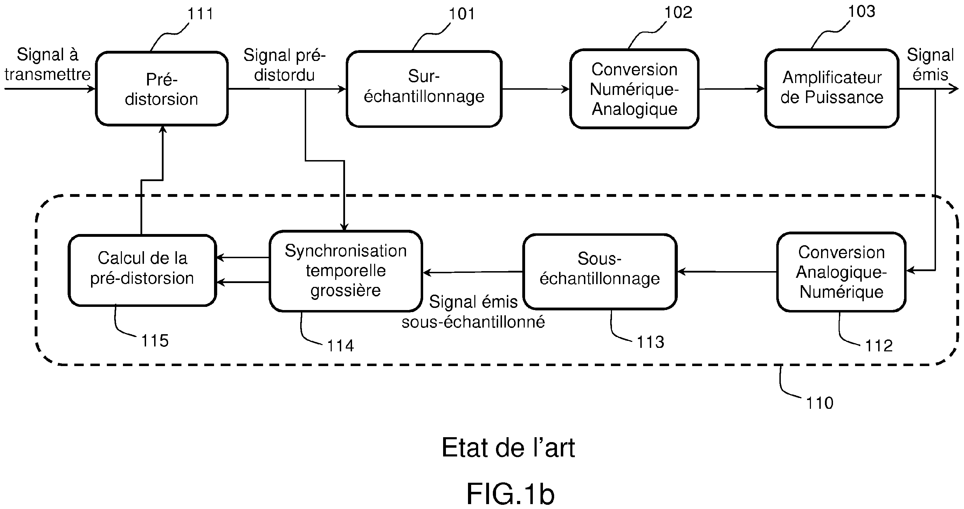

La figure 1b décrit les principaux éléments d'un équipement de transmission selon l'état de l'art mettant en oeuvre une prédistorsion numérique du signal. Pour ceci, une boucle de calcul de prédistorsion 110 est ajoutée à la chaîne de transmission de la figure 1a, dont l'objet est de calculer les coefficients d'une prédistorsion 111 appliquée au signal à transmettre. La boucle de calcul de prédistorsion prend comme entrées le signal émis après amplification et le signal prédistordu (ou le signal à transmettre), afin de calculer les coefficients de la prédistorsion 111.

Dans la représentation de la figure 1b, la boucle de calcul de prédistorsion comprend la conversion du signal émis en un signal numérique par un convertisseur analogique-numérique (ou CAN) 112, puis son sous-échantillonnage 113. Le signal sous-échantillonné et le signal prédistordu sont synchronisés temporellement 114, de manière à ce qu'ils puissent être comparés afin de calculer 115 les coefficients de prédistorsion à appliquer au signal à transmettre. La resynchronisation consiste à avancer ou retarder l'un des deux signaux en fonction du temps de propagation de groupe afin de pouvoir les comparer. Lorsque le signal sous-échantillonné et le signal à transmettre resynchronisés sont égaux, alors la prédistorsion compense parfaitement les non-linéarités de l'amplificateur.

Les données sont transmises par blocs d'échantillons consécutifs ou bien en continu. Le calcul des coefficients de prédistorsion peut alors lui aussi être réalisé par blocs de données ou en continu.

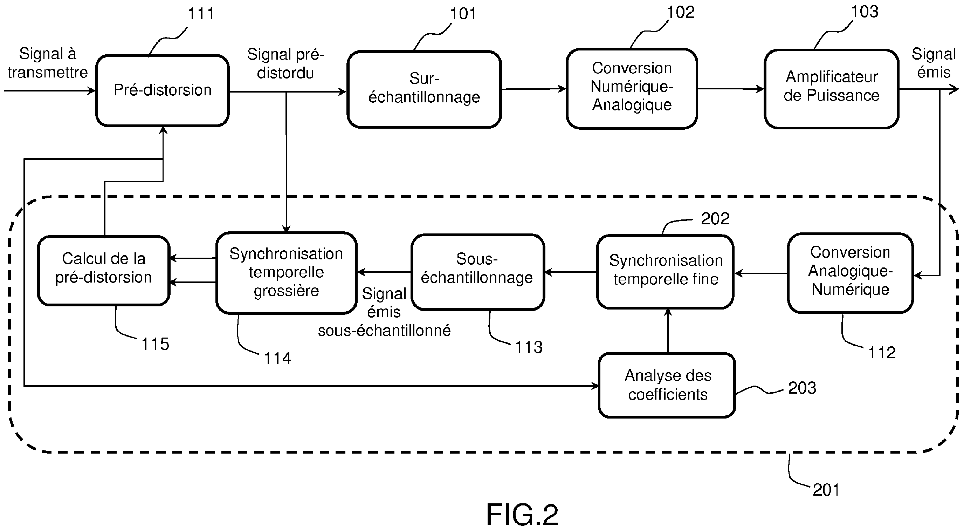

La représentation de la figure 1b, ainsi que celle présentée plus tard pour la figure 2, est la représentation la plus généralement envisagée de par sa simplicité et son faible coût d'implémentation. De nombreuses variations peuvent lui être appliquées, qui apparaitront comme évidentes à l'homme du métier et ne modifieront pas les performances de la prédistorsion. En particulier, la boucle de calcul de prédistorsion connaissant les coefficients appliqués lors de la prédistorsion 111, le signal à transmettre peut être utilisé comme entrée de cette boucle en lieu et place du signal prédistordu. De même, la prédistorsion peut être appliquée après le sur-échantillonnage du signal, ce qui n'a aucun effet sur les performances de la prédistorsion mais augmente la complexité d'implémentation. Enfin, la boucle de calcul de prédistorsion peut prendre comme entrées le signal prédistordu après sur-échantillonnage et le signal émis numérisé avant sous-échantillonnage, ce qui a là aussi un impact sur la complexité d'implémentation mais pas sur les performances. Par la suite, on considèrera, de manière non limitative et à titre d'illustration seulement, que la boucle de calcul de prédistorsion prend comme entrées le signal prédistordu avant sur-échantillonnage 101 et le signal émis après sous-échantillonnage 113.

La désynchronisation temporelle entre le signal sous-échantillonné et le signal prédistordu (ou le signal à transmettre) provient des temps de propagation de groupe des fonctions numériques et analogiques. A l'issu de l'étape de synchronisation temporelle 114, les deux signaux doivent être parfaitement synchronisés temporellement afin d'être ensuite comparés. En effet, le moindre décalage temporel résiduel entre les deux signaux est interprété comme un défaut du à l'amplificateur de puissance, et est pris en compte lors du calcul 115 des coefficients de prédistorsion. La prédistorsion 111 applique alors au signal à transmettre des distorsions ne correspondant pas aux dégradations de l'amplificateur, qui peuvent dégrader le spectre du signal émis.

Cette étape de synchronisation temporelle, et en particulier le choix de l'instant d'échantillonnage dans le sous-échantillonneur 113, est donc une fonction clé sur laquelle reposent les performances de l'algorithme de prédistorsion, et qui conditionne le choix de l'amplificateur de puissance.

Dans l'état de la technique, il existe trois grandes familles de solutions permettant de réaliser la synchronisation temporelle 114 entre le signal prédistordu et le signal émis sous-échantillonné.

La première solution consiste à synchroniser grossièrement les signaux en utilisant un instant d'échantillonnage pré-calculé et fixe, en considérant que le temps de propagation de groupe du signal est déterministe et invariant dans le temps. Cet instant d'échantillonnage peut être calculé théoriquement à partir des temps de groupe de chacun des composants analogiques et numériques, ou mesuré en utilisant un signal de calibration. Si le temps de groupe peut être considéré comme déterministe et invariant dans le temps en ce qui concerne les éléments numériques, ce n'est pas vrai pour ce qui concerne la partie analogique, où les réponses des composants, et donc le temps de propagation de groupe, varie en fonction de l'âge des composants, de la température et de la fréquence de travail. Cette solution de synchronisation temporelle n'est donc pas optimale : les coefficients de prédistorsion calculés ne permettront pas de tirer pleinement profit de la capacité de linéarisation.

La deuxième solution, décrite par exemple dans la demande de brevet EP 1 331 729 A1, consiste à déterminer le décalage entre les signaux par le biais de corrélations réalisées dans le domaine sous-échantillonné, c'est-à-dire avant le sur-échantillonneur 101 et après le sous-échantillonneur 113. Le problème de cette technique est que le sous-échantillonnage des signaux dans la boucle de prédistorsion n'est pas synchronisé avec le sur-échantillonnage des signaux à transmettre, Il existe donc un retard factionnaire, inférieur à la durée d'un échantillon, qui vient dégrader la qualité de la prédistorsion. C'est ce retard fractionnaire qu'il est important d'estimer et de compenser. Une des possibilités est alors d'implémenter des techniques complexes d'interpolation des résultats de la corrélation pour avoir des résultats dont la précision est inférieure à un échantillon. La précision de la corrélation augmentant avec la longueur des séquences, les séquences corrélées doivent être de longueur importante. De plus, la resynchronisation des signaux est alors complexe car elle nécessite l'interpolation des signaux à resynchroniser pour compenser le retard fractionnaire. Tout ceci est donc complexe à mettre en oeuvre et un impact important sur le coût d'implémentation de l'algorithme de prédistorsion.

La troisième solution, décrite par exemple dans la demande de brevet EP 2 947 833 A1, consiste à réaliser les corrélations de la deuxième solution sur des signaux pris dans le domaine sur échantillonné, c'est-à-dire après le sur-échantillonneur 101 et avant le sous-échantillonneur 113. Si la précision qui en découle est importante, les corrélateurs requis sont de taille importante, ce qui est très coûteux en termes de complexité des calculs.

Il y a donc un besoin pour une méthode permettant de synchroniser finement les signaux dans un algorithme de prédistorsion, et dont la complexité d'implémentation soit limitée.

Pour répondre au problème technique de la complexité des opérations de resynchronisation requises dans les chaînes de prédistorsion des équipements de transmission de signaux tout en offrant les meilleures performances possibles, l'invention décrit un équipement et procédé de synchronisation temporelle de deux signaux dans une boucle de calcul de prédistorsion, dans lequel la synchronisation temporelle comprend deux parties :

- une première partie, grossière, dans laquelle le décalage appliqué est un décalage grossier. Ce premier décalage peut par exemple être calculé théoriquement à partir des éléments de la chaîne d'émission, être mesuré en usine ou sur l'équipement, ou être calculé en réalisant la corrélation entre les deux signaux, et

- une deuxième partie, fine, dans laquelle le décalage appliqué est calculé à partir des coefficients de prédistorsion appliqués au signal avant son émission.

Cette deuxième partie permet de corriger de manière fine les décalages, avec une précision inférieure à la durée d'un échantillon dans le domaine sous-échantillonné, et de suivre les variations du temps de groupe de la chaîne d'émission liés au vieillissement des composants, aux variations de la fréquence porteuse ou de la température.

Par rapport à l'état de l'art antérieur, cette solution a en outre l'avantage d'être très simple à implémenter et peu coûteuse en calculs.

Elle présente un intérêt particulier pour les signaux radio fréquences de type mono-porteuse à enveloppe non constante, mais surtout pour les modulations de type multi-porteuses, qui appartiennent à la famille des signaux à enveloppe non-constante. En effet, ces signaux présentent généralement des variations importantes d'amplitude, ce qui les rend très sensibles aux non linéarités des amplificateurs de puissance. Par exemple, les liaisons de radiocommunications Hautes Fréquences militaires offrent une capacité de transmission hors ligne de vue (en anglais Beyond Line of Sight, ou BLOS) s'appuyant sur les propriétés de réflexion des couches atmosphériques, ce qui leur permet de réaliser des communications à longue voire très longue distance sans nécessiter le recours à une liaison satellite ou des stations relai. Ces liaisons transmettent des signaux à enveloppe non constante sur des distances très importantes. Le rendement de l'amplificateur de puissance est donc primordial pour ce type de communications. L'implémentation d'une méthode de prédistorsion la plus précise possible est un des moyens qui permettent d'atteindre les objectifs de portée visés.

Cependant, l'invention s'applique de manière totalement identique, quelque soit le type de signal transmis et le support de transmission. Il peut ainsi être mis en oeuvre par exemple dans le cadre de transmissions par fibre optique.

A cet effet, l'invention décrit un procédé de synchronisation temporelle de deux signaux dans un dispositif de transmission d'un signal. Les deux signaux synchronisés sont utilisés par une boucle de calcul de prédistorsion pour calculer des coefficients de prédistorsion appliqués au signal à transmettre avant son amplification et son émission. Le procédé selon l'invention comprend consécutivement :

- l'application, à l'un des deux signaux comparés, d'un premier décalage temporel correspondant sensiblement à l'écart temporel entre les deux signaux, et
- l'application, à l'un des deux signaux comparés, d'un deuxième décalage temporel correspondant sensiblement à l'écart temporel entre les deux signaux après application du premier décalage temporel, le deuxième décalage temporel étant calculé à partir desdits coefficients de prédistorsion.

Le premier décalage correspond à un décalage grossier, soit calculé théoriquement, soit mesuré à partir d'un signal de calibration, soit obtenu par corrélation entre les deux signaux à synchroniser temporellement, ou par tout autre moyen connu de l'homme du métier.

Selon l'invention, les deux signaux à synchroniser temporellement sont :

- un premier signal correspondant au signal à transmettre avant ou après application de la prédistorsion,
- un deuxième signal correspondant au signal émis.

Selon l'invention, le deuxième décalage temporel est calculé à partir des coefficients de prédistorsion qui s'expriment linéairement en fonction du signal à transmettre.

Selon un mode de réalisation, en particulier lorsque l'algorithme de prédistorsion mis en oeuvre est un algorithme de type GMP, le deuxième décalage temporel $\Delta t$ vaut :

$$\Delta t = -R\acute{e}el\left[\frac{\sum_{l=0}^{L_a-1} l.a_{0,l}}{\sum_{l=0}^{L_a-1} a_{0,l}}\right],$$

où $a_{0,l}$ représente $L_a$ coefficients de prédistorsion s'exprimant linéairement en fonction du signal à transmettre, et $R\acute{e}el(X)$ la partie réelle du nombre complexe $X$.

Selon un mode de réalisation, en particulier lorsque l'algorithme de prédistorsion mis en oeuvre est un algorithme de type DVR, le deuxième décalage temporel Δt vaut :

$$\Delta_t = - R\acute{e}el\left[\frac{\sum_{l=0}^{M} l \cdot a_l}{\sum_{l=0}^{M} a_l}\right],$$

où $a_l$ représente $M$ coefficients de prédistorsion s'exprimant linéairement en fonction du signal à transmettre, et *Réel(X)* la partie réelle du nombre complexe *X*.

Avantageusement, les traitements réalisés par la boucle de calcul de prédistorsion comprennent le sous-échantillonnage du signal émis, le deuxième décalage temporel étant appliqué avant ce sous-échantillonnage.

L'invention décrit également un dispositif de transmission d'un signal comprenant une boucle de calcul de prédistorsion pour calculer des coefficients de prédistorsion appliqués au signal à transmettre, et un amplificateur pour amplifier et émettre le signal prédistordu, tel que défini dans la revendication 6.

## *Description*

L'invention sera mieux comprise et d'autres caractéristiques et avantages apparaîtront mieux à la lecture de la description qui suit, donnée à titre non limitatif, et grâce aux figures annexées parmi lesquelles :

- La figure 1a décrit les principaux éléments d'un équipement de transmission selon l'état de l'art ne mettant pas en oeuvre de prédistorsion ;

- La figure 1b décrit les principaux éléments d'un équipement de transmission selon l'état de l'art mettant en oeuvre une prédistorsion numérique du signal ;

- La figure 2 décrit les principaux éléments d'un équipement de transmission d'un signal comprenant un dispositif de prédistorsion de l'amplificateur de puissance selon un mode de réalisation de l'invention ;

- Les figures 3a et 3b sont des représentations, données à titre d'illustration, de signaux resynchronisés respectivement sans mettre en oeuvre et en mettant en oeuvre l'invention ;

- La figure 4 est une représentation sous la forme d'un diagramme d'état des étapes d'un mode de réalisation du procédé de synchronisation temporelle selon l'invention.

La figure 2 décrit les principaux éléments d'un équipement de transmission d'un signal comprenant un dispositif de prédistorsion de l'amplificateur de puissance selon un mode de réalisation de l'invention.

Ce mode de réalisation comprend l'ensemble des éléments de la chaîne de transmission selon l'état de l'art décrite en figure 1b. En particulier, elle met en oeuvre un mécanisme de synchronisation temporelle dite grossière 114.

Ce mécanisme est réalisé selon les méthodes connues de l'état de l'art, comme par exemple :

- par caractérisation du temps de groupe de la chaîne de transmission et de la boucle de calcul de prédistorsion, en utilisant les temps de groupe moyens de chacun des éléments numériques et analogiques qui la composent ;

- par mesure du temps de groupe de la chaîne de transmission et de la boucle de calcul de prédistorsion, en utilisant par exemple un signal particulier tel qu'un Dirac et en mesurant le décalage de position de ce Dirac sur le signal prédistordu et le signal émis sous échantillonné ;

- par corrélations entre le signal prédistordu et le signal émis faites dans le domaine sous-échantillonné, sur des séquences de taille raisonnable de manière à ne pas être trop coûteuses en implémentation.

Le premier mécanisme de synchronisation temporelle a pour but de compenser le plus gros du décalage temporel entre les deux signaux à synchroniser. Le temps de propagation de groupe total (de l'émission à la réception) étant généralement très grand devant la capacité d'estimation de la prédistorsion, il est attendu du premier mécanisme de synchronisation qu'il offre une précision suffisante pour pouvoir calculer les coefficients de la prédistorsion, et non qu'il permette d'atteindre les performances optimales de l'algorithme de prédistorsion. C'est pourquoi on parle de synchronisation temporelle grossière corrigeant sensiblement le décalage entre les signaux. En pratique, la précision attendue de cette première synchronisation est qu'elle permette un recalage des signaux à quelques échantillons près, et de préférence à plus ou moins un échantillon près, au rythme échantillon des signaux qui lui parviennent.

La chaîne de prédistorsion 201 de ce mode de réalisation comprend en outre un mécanisme de synchronisation temporelle dite fine 202.

Le mécanisme de synchronisation temporelle fine a pour but de corriger l'écart temporel résiduel entre les deux signaux après compensation du décalage temporel grossier. La précision attendue par la synchronisation temporelle fine est inférieure à la durée d'un échantillon dans le domaine sous-échantillonné. Contrairement à la synchronisation grossière, la synchronisation fine ne se base pas sur une analyse des signaux mais sur les coefficients de la prédistorsion. Ainsi, la boucle de calcul de prédistorsion 201 comprend un module d'analyse des coefficients 203, qui prend comme entrée les coefficients calculés par le module 115 pour déterminer le décalage devant être appliqué par la synchronisation fine au signal émis numérisé. Ce décalage dépendant de celui appliqué par la synchronisation grossière, il peut s'agir d'un retard ou d'une avance.

Le choix de l'endroit où est effectuée la synchronisation fine dans la boucle de calcul de prédistorsion n'a pas d'effet sur les performances de la prédistorsion. En effet, elle peut indifféremment se situer avant ou après le sous échantillonneur 113, ou même se situer après la synchronisation temporelle grossière. Cependant, la synchronisation fine vise à décaler les signaux avec une granularité inférieure au temps échantillon dans le domaine sous-échantillonné. Si elle est réalisée après le sous-échantillonnage 113, il est alors nécessaire d'interpoler les signaux pour les avancer ou les retarder, ce qui peut être coûteux en termes de calculs à réaliser. Si elle est réalisée avant le sous-échantillonneur 113, elle nécessite alors uniquement la mise en oeuvre d'une ligne à avance ou à retard. Son coût d'implémentation est donc inférieur lorsqu'elle est réalisée avant le sous-échantillonnage du signal émis, comme c'est le cas dans le mode de réalisation représenté en figure 2.

Afin de calculer le décalage devant être appliqué par la synchronisation temporelle fine 202, l'invention s'appuie sur les spécificités de la linéarisation. En effet, mis à part pour des applications très bande étroite, ou bien pour des spécifications de linéarités et d'émissions hors bande très relâchées, le procédé de linéarisation doit tenir compte des effets mémoire de l'amplificateur de puissance. Les coefficients de la prédistorsion ont donc intrinsèquement une dimension temporelle lorsque les effets mémoires sont considérés. Par conséquent, l'information temporelle de synchronisation est disponible dans ces coefficients.

La prise en compte des effets mémoire de l'amplificateur dans les coefficients de prédistorsion permet à l'algorithme de compenser en partie l'imprécision de la synchronisation temporelle grossière. L'information de synchronisation présente dans les coefficients est alors plus précise que la synchronisation initiale.

Il existe de nombreux algorithmes de prédistorsion numérique du signal (en anglais Digital Pré-Distortion, ou DPD), qui prennent en compte les effets mémoire de l'amplificateur de puissance. La plupart, comme par exemple l'algorithme MP (en anglais Memory Polynomial), le GMP, le DDR (en anglais Dynamic Déviation Réduction), le VS (Volterra Series), modélisent les non linéarités de l'amplificateur par un modèle polynomial. Ce modèle polynomial s'exprime par des coefficients pouvant être classés dans deux catégories :

- les coefficients linéaires, qui s'expriment de manière linéaire par rapport à l'entrée, et

- les coefficients non linéaires.

Les coefficients non linéaires agissent en particulier sur les remontées de spectre à l'écart de la fréquence porteuse, généralement à de niveaux de puissance très faibles. A l'inverse, les effets des décalages de synchronisation temporelle sont majoritairement portés par les coefficients linéaires de la prédistorsion.

L'invention fait donc l'hypothèse simplificatrice que l'effet du décalage temporel est porté par les coefficients linéaires seulement. Par la suite, l'algorithme GMP est utilisé à titre d'exemple afin d'illustrer le calcul du décalage à partir de des coefficients de prédistorsion, mais l'invention s'applique de manière équivalente quel que soit l'algorithme de prédistorsion utilisé dès lors qu'il s'exprime selon un modèle prenant en compte les effets mémoire.

Dans GMP, le signal prédistordu $y(n)$, résultant de la prédistorsion du signal à transmettre $x(n)$, peut s'exprimer de la manière suivante en fonction des coefficients $a_{k,l}$, $b_{k,l,m}$, $c_{k,l,m}$ :

$$y(n) \quad = \quad \sum_{k=0}^{K_a-1} \sum_{l=0}^{L_a-1} a_{k,l} x(n-l) |x(n-l)|^k$$

$$+ \sum_{k=1}^{K_b} \sum_{l=0}^{L_b-1} \sum_{m=1}^{M_b} b_{k,l,m} x(n-l) |x(n-l-m)|^k \qquad (1)$$

$$+ \sum_{k=1}^{K_c} \sum_{l=0}^{L_c-1} \sum_{m=1}^{M_c} c_{k,l,m} x(n-l) |x(n-l+m)|^k$$

Les coefficients $a_{k,l}$, $b_{k,l,m}$, et $c_{k,l,m}$ sont calculés par le module 115. Ils peuvent être obtenus, par exemple, en utilisant la méthode des moindres carrés.

Dans l'approche proposée, seuls les termes linéaires sont conservés, c'est-à-dire, pour GMP, les $L_a$ coefficients $a_{k,l}$ pour $k = 0$, qui correspond aux coefficients de type « A » (première ligne de l'équation (1)) de l'algorithme GMP. En effet, les $L_a$ coefficients $a_{k,l}$ pour $k = 0$ sont les seuls qui varient linéairement en fonction du signal $x(n)$ à transmettre, les autres coefficients correspondant à des termes non linéaires. Ainsi, l'équation (1) peut être simplifiée en :

$$y(n) = \sum_{l=0}^{L_a-1} a_{0,l} \cdot x(n-l). \qquad (2)$$

Pour en déduire le décalage $\Delta t$, la transformée en Z de l'équation (2) est calculée, soit :

$$H(Z) = \sum_{l=0}^{L_a-1} Z^{-l} \cdot a_{0,l}. \qquad (3)$$

La réponse en pulsation normalisée $\omega_n = \omega/f_{DPD}$ (avec $f_{DPD}$ la fréquence d'échantillonnage à laquelle fonctionne la pré-distorsion) est obtenue en remplaçant l'opérateur $Z$ par $e^{j\omega n}$ :

$$H(e^{j\omega_n}) = \sum_{l=0}^{L_a-1} e^{-j\omega_n l} \cdot a_{0,l}. \qquad (4)$$

Le délai $\Delta_t$ recherché correspond à l'opposé du temps de propagation de groupe $TPG$ :

$$\Delta_t = -TPG|_{\omega_n=0} = \left.\frac{d\left(Arg[H(e^{j\omega_n})]\right)}{d\,\omega_n}\right|_{\omega_n=0}, \qquad (5)$$

avec $Arg[X]$ l'argument de $X$.

La relation liant le logarithme népérien d'un nombre complexe et son argument est :

$$ln(x) = ln|x| + j \cdot Arg[x]. \qquad (6)$$

Le délai s'exprime alors de la manière suivante :

$$\Delta_t \;=\; \left.\frac{d\left(Arg\left[H\!\left(e^{j\omega_n}\right)\right]\right)}{d\,\omega_n}\right|_{\omega_n=0}$$

$$\;=\; \left.\frac{d\left(Imag\left[ln\left(H\!\left(e^{j\omega_n}\right)\right)\right]\right)}{d\,\omega_n}\right|_{\omega_n=0} \tag{7}$$

$$\;=\; Imag\left[\left.\frac{d\left(ln\left(H\!\left(e^{j\omega_n}\right)\right)\right)}{d\,\omega_n}\right|_{\omega_n=0}\right]$$

avec *Imag*[*X*] la partie imaginaire du nombre complexe *X*.

La dérivée de *ln* ($H(e^{j\omega n})$) vaut:

$$\frac{d\left(ln\left(H\!\left(e^{j\omega_n}\right)\right)\right)}{d\,\omega_n} \;=\; \frac{\dfrac{d\left(H\!\left(e^{j\omega_n}\right)\right)}{d\,\omega_n}}{H\!\left(e^{j\omega_n}\right)} \tag{8}$$

$$\;=\; \frac{\sum_{l=0}^{L_a-1} -j\cdot l\cdot e^{-j\omega_n l}\cdot a_{0,l}}{\sum_{l=0}^{L_a-1} e^{-j\omega_n l}\cdot a_{0,l}}$$

Le signal étant en bande de base, soit à la fréquence nulle, on cherche le temps de groupe au centre du signal utile, c'est-à-dire à la pulsation $\omega_n = 0$ :

$$\left.\frac{d\left(ln\left(H\!\left(e^{j\omega_n}\right)\right)\right)}{d\,\omega_n}\right|_{\omega_n=0} \;=\; \frac{\sum_{l=0}^{L_a-1} -j\cdot l\cdot a_{0,l}}{\sum_{l=0}^{L_a-1} a_{0,l}}. \tag{9}$$

Bien entendu, lorsque le signal n'est pas en bande de base, le $\omega_n$ considéré peut être adapté en conséquence.

Le délai $\Delta_t$ est exprimé grâce à la formulation précédente de la manière suivante :

$$\Delta_t \;=\; Imag\left[\left.\frac{d\left(ln\left(H\!\left(e^{j\omega_n}\right)\right)\right)}{d\,\omega_n}\right|_{\omega_n=0}\right] \tag{10}$$

$$\;=\; Imag\left[-j\cdot\frac{\sum_{l=0}^{L_a-1} l\cdot a_{0,l}}{\sum_{l=0}^{L_a-1} a_{0,l}}\right]$$

Finalement, l'expression simplifiée du délai $\Delta_t$ est :

$$\Delta_t = -\,R\acute{e}el\left[\frac{\sum_{l=0}^{L_a-1} l\cdot a_{0,l}}{\sum_{l=0}^{L_a-1} a_{0,l}}\right], \tag{11}$$

avec *Réel*[*X*] la partie réelle du nombre complexe *X*.

Le décalage $\Delta_t$ devant être appliqué par la synchronisation temporelle fine peut donc être calculé très simplement

à partir des $L_a$ coefficients de prédistorsion $a_{0,l}$.

L'équation (11) peut être généralisée en prenant en compte des coefficients linéaires d'indice négatifs, c'est-à-dire pour des indices $l$ = [-$L'_a$; $L_a$ - 1] au lieu de $l$ = [0; $L_a$ - 1].

Lorsque le modèle de prédistorsion utilisé ne prend pas en compte les effets mémoire, comme par exemple les algorithmes basés sur un modèle polynomial simple tel que celui décrit à l'équation (12) :

$$y(n) = \sum_{k=0}^{K_a-1} a_k x(n) |x(n)|^k, \qquad (12)$$

il est impossible de calculer le temps de groupe à partir du seul coefficient linéaire $a_0$. Quelques coefficients linéaires peuvent alors être ajoutés pour prendre en compte le retard entre les deux signaux, par exemple :

$$y(n) = \sum_{k=0}^{K_a-1} a_k x(n) |x(n)|^k + \sum_{l=0}^{L_a-1} a_{0,l} x(n - l). \qquad (13)$$

Ce modèle se rapporte à celui présenté à l'équation (2) sur lequel l'invention peut être mise en oeuvre simplement.

L'équation (11), permettant d'exprimer le retard fin de propagation à partir des coefficients de prédistorsion, est applicable à tous les modèles de prédistorsion dérivés des séries de Volterra (SV, MP, GMP, DDR, etc...). Cependant, l'invention s'applique pour toutes les autres familles de prédistorsion. Par exemple, la relation entre l'entrée et la sortie de la prédistorsion de type DVR (acronyme anglais pour Decomposed Vector Rotation) décrite dans A. Zhu, "Decomposed Vector Rotation-Based Behavioral Modeling for Digital Predistortion of RF Power Amplifiers," in IEEE Transactions on Microwave Theory and Techniques, vol. 63, no. 2, pp. 737-744, Feb. 2015, s'exprime de la manière suivante :

$$
\begin{aligned}
y(n) \quad = \quad & \sum_{i=0}^{M} a_i \, x(n - i) \\
& + \sum_{k=1}^{K} \sum_{i=0}^{M} c_{ki,1} \big| |x(n - i)| - \beta_k \big| e^{j\theta(n-i)} \\
& + \sum_{k=1}^{K} \sum_{i=0}^{M} c_{ki,21} \big| |x(n - i)| - \beta_k \big| e^{j\theta(n-i)} |x(n)| \\
& + \sum_{k=1}^{K} \sum_{i=1}^{M} c_{ki,22} \big| |x(n - i)| - \beta_k \big| x(n) \\
& + \sum_{k=1}^{K} \sum_{i=1}^{M} c_{ki,23} \big| |x(n - i)| - \beta_k \big| x(n - i) \\
& + \sum_{k=1}^{K} \sum_{i=1}^{M} c_{ki,24} \big| |x(n)| - \beta_k \big| x(n - i) \\
& + \cdots
\end{aligned}
$$

De la même manière que pour le modèle GMP, si l'on ne considère que les termes linéaires $a_i$ du modèle DVR, l'expression du délai $\Delta_t$ s'écrit :

$$\Delta_t = - R\acute{e}el\left[\frac{\sum_{l=0}^{M} l \cdot a_{\mathrm{l}}}{\sum_{l=0}^{M} a_{\mathrm{l}}}\right], \qquad (14)$$

Le dispositif de transmission d'un signal selon l'invention permet donc de tirer profit de la faible complexité d'implémentation d'une synchronisation grossière, puis exploite la dimension temporelle des coefficients de prédistorsion calculés pour affiner un instant d'échantillonnage optimal. Il est très simple à mettre en oeuvre et ne requiert pas de calculs complexes.

S'agissant d'un algorithme de prédistorsion numérique, l'ensemble des traitements, c'est-à-dire l'analyse des coefficients 203 et l'application de la synchronisation temporelle fine 202, sont réalisés par un circuit de calculs numérique. Par exemple, ils peuvent être réalisés par une machine de calculs reprogrammable comme un processeur, un DSP (acronyme anglais pour Digital Signal Processor, ou processeur de signal numérique), ou un micro contrôleur. Ils peuvent également être réalisés par une machine de calculs dédiée, comme un FPGA (acronyme anglais pour Field-Programmable Gate Array, ou circuit intégré programmable) ou un ASIC (acronyme anglais pour Application Spécifie Integrated Circuit, ou circuit intégré à application spécifique), ou par tout autre module matériel permettant l'exécution de calculs.

Le circuit de calcul numérique peut être embarqué dans un équipement de transmission RF ou filaire, ou dans tout autre équipement destiné à émettre un signal modulé, dans des conditions réelles ou en laboratoire, comme par exemple un générateur de signal ou un ordinateur.

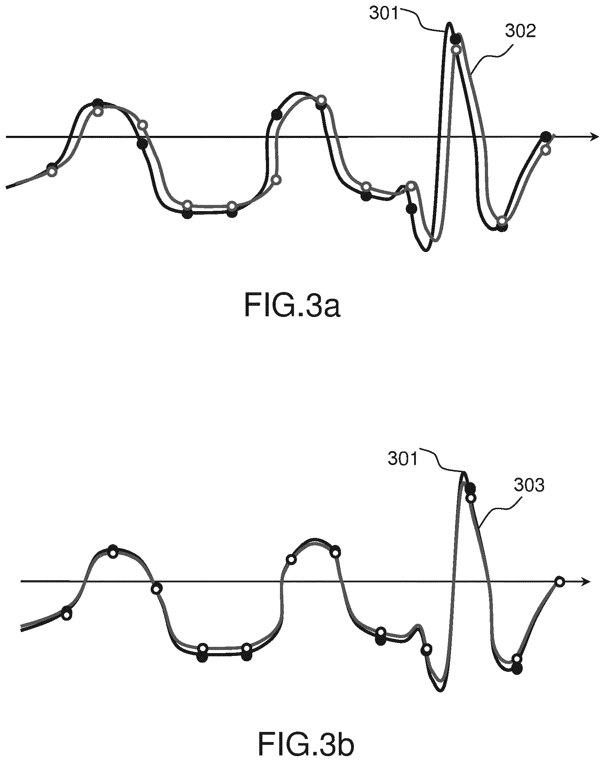

Les figures 3a et 3b sont des représentations, données à titre d'illustration, de signaux resynchronisés respectivement sans mettre en oeuvre et en mettant en oeuvre l'invention

Dans la figure 3a, le signal 301 à transmettre et le signal 302 émis et sous échantillonné sont resynchronisés temporellement selon les méthodes faible complexité connues de l'état de l'art. La compensation temporelle est comparable à la compensation temporelle réalisée par la synchronisation temporelle grossière réalisée par un équipement de transmission selon un mode de réalisation de l'invention. Un retard, correspondant au retard fractionnaire lié aux différences d'instants d'échantillonnage entre le sur-échantillonneur 101 et le sous-échantillonneur 113, fait que les deux signaux ne sont pas exactement en phase, ce qui a des conséquences sur les coefficients de prédistorsion calculés et donc sur les remontées de spectre du signal émis.

A l'inverse, dans la figure 3b, le signal à transmettre 301 et le signal émis sous-échantillonné 303 sont resynchronisés tel que décrit dans l'invention. Cette resynchronisation comprend la resynchronisation temporelle grossière, permettant de resynchroniser les signaux à quelques échantillons près, et la resynchronisation fine, estimée à partir des coefficients de prédistorsion. Les deux signaux sont alors parfaitement synchronisés, ce qui permet d'optimiser le calcul des coefficients de prédistorsion, et donc l'allure du spectre émis après amplification par un amplificateur dont la réponse n'est pas nécessairement linéaire.

L'invention porte également sur un procédé de synchronisation temporelle de deux signaux dans un dispositif de transmission d'un signal, les deux signaux étant utilisés par une boucle de calcul de prédistorsion pour calculer des coefficients de prédistorsion appliqués au signal à transmettre avant son amplification et son émission.

Suivant le mode de réalisation, les deux signaux peuvent être le signal prédistordu et le signal émis, pris indifféremment dans le domaine sous-échantillonné ou dans le domaine sur-échantillonné. Il peut également s'agir du signal à transmettre (c'est-à-dire avant prédistorsion) et du signal émis.

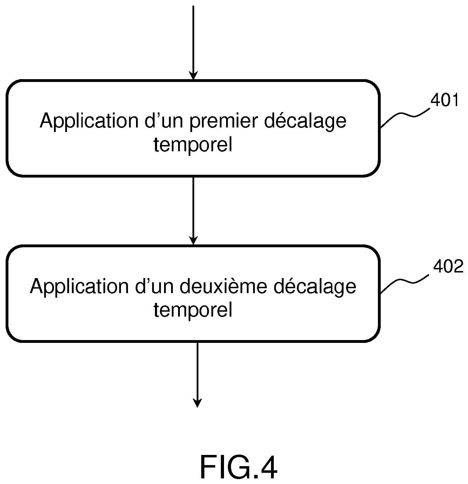

La figure 4 est une représentation sous la forme d'un diagramme d'état des étapes d'un mode de réalisation du procédé de synchronisation temporelle selon l'invention.

Ce procédé comprend une première étape 401 d'application d'un premier décalage temporel 114, grossier. Ce premier décalage temporel correspond sensiblement à l'écart entre les deux signaux à synchroniser, si ce n'est que, pour que son coût d'implémentation soit le plus faible possible, il ne cherche pas à estimer le décalage avec une précision importante. Ce décalage peut alors être un décalage calculé théoriquement, mesuré à partir d'un signal de calibration, ou obtenu par corrélation entre les deux signaux à synchroniser temporellement, de préférence dans le domaine sous-échantillonné en utilisant des séquences de taille raisonnable. En pratique, le signal à transmettre, ou le signal prédistordu, sera généralement stocké dans un tampon mémoire, la boucle de prédistorsion venant récupérer le signal dans le tampon mémoire à une position qui dépend de l'instant présent et du décalage temporel calculé.

Il comprend également une deuxième étape 402 d'application d'un deuxième décalage temporel 202, fin. Ce deuxième décalage temporel cherche à compenser l'écart résiduel entre les signaux après application du décalage temporel grossier. Il est calculé à partir des coefficients de prédistorsion, et cherche à atteindre une précision inférieure à la durée d'un échantillon dans le domaine sous-échantillonné. Avantageusement, seuls les coefficients de prédistorsion linéaires sont utilisés pour calculer la valeur de ce deuxième décalage. Avantageusement, de manière à réduire la complexité d'implémentation du procédé, le deuxième décalage est appliqué avant le sous-échantillonnage 113 du signal émis.

Les deux étapes sont réalisées consécutivement, peu importe leur ordre, sur toutes les données utilisées par la boucle de calcul de prédistorsion.

Différents modes de réalisation du procédé sont possibles.

Selon un premier mode de réalisation, la synchronisation grossière est une valeur fixe, calculée théoriquement ou en usine. Dans ce mode de réalisation, le décalage réalisé par cette synchronisation ne varie pas au cours du temps.

Selon un deuxième mode de réalisation, la synchronisation grossière est calculée grâce à un signal de calibration, ou par corrélation des signaux à transmettre (prédistordus ou non) et du signal émis numérisé. Elle peut alors être calculée à des moments précis, comme par exemple lors de l'initialisation de l'équipement, ou à intervalles réguliers, ou calculée au fil de l'eau en continu ou par blocs de données à transmettre.

Dans tous ces modes de réalisation, la synchronisation fine a pour rôle de corriger les défauts de cette synchronisation, et de suivre les variations du temps de groupe. Elle peut elle aussi être réalisée à des instants spécifiques, à des intervalles réguliers, ou de manière continue tout au long de la transmission.

Lorsque les coefficients de prédistorsion appliquées aux données à transmettre ne les modifient pas, ce qui peut-être le cas lors du passage des premières données à travers la boucle de calcul de prédistorsion, le décalage $\Delta t$ appliqué par la synchronisation fine est nul.

## Revendications

1. Procédé de synchronisation temporelle de deux signaux dans un dispositif de transmission d'un signal, les deux signaux étant utilisés par une boucle de calcul de prédistorsion numérique (201) pour calculer des coefficients de prédistorsion (115) appliqués au signal à transmettre avant son amplification (103) et son émission, les deux signaux utilisés par la boucle de calcul de prédistorsion étant :

   - un premier signal correspondant au signal à transmettre avant ou après application de la prédistorsion,
   - un deuxième signal correspondant au signal émis,

   le procédé étant **caractérisé en ce qu'**il comprend consécutivement :

   - l'application à l'un des deux signaux (601) d'un premier décalage temporel (114) correspondant sensiblement à l'écart temporel entre les deux signaux, et
   - l'application à l'un des deux signaux (602) d'un deuxième décalage temporel (202) correspondant sensiblement à l'écart temporel entre les deux signaux après application du premier décalage temporel, le deuxième décalage temporel étant calculé à partir desdits coefficients de prédistorsion qui s'expriment linéairement en fonction du signal à transmettre.

2. Procédé de synchronisation temporelle de deux signaux selon la revendication 1, dans lequel le premier décalage temporel est un décalage calculé théoriquement, mesuré à partir d'un signal de calibration, ou obtenu par corrélation entre les deux signaux à synchroniser temporellement.

3. Procédé de synchronisation temporelle de deux signaux selon la revendication 2, dans lequel la boucle de prédistorsion met en oeuvre un algorithme de type Generalized Memory Polynomial, et où le deuxième décalage temporel $\Delta t$ vaut :

$$\Delta t = -R\acute{e}el\left[\frac{\sum_{l=0}^{L_a-1} l.a_{0,l}}{\sum_{l=0}^{L_a-1} a_{0,l}}\right],$$

   où $a_{0,l}$ représente $L_a$ coefficients de prédistorsion s'exprimant linéairement en fonction du signal à transmettre, et $R\acute{e}el(X)$ la partie réelle du nombre complexe $X$.

4. Procédé de synchronisation temporelle de deux signaux selon la revendication 2, dans lequel la boucle de prédistorsion met en oeuvre un algorithme de type Decomposed Vector Rotation, et où le deuxième décalage temporel $\Delta t$ vaut :

$$\Delta_t = -\,R\acute{e}el\left[\frac{\sum_{l=0}^{M} l \cdot a_l}{\sum_{l=0}^{M} a_l}\right],$$

où $a_l$ représente $M$ coefficients de prédistorsion s'exprimant linéairement en fonction du signal à transmettre, et *Réel(X)* la partie réelle du nombre complexe $X$.

5. Procédé de synchronisation temporelle de deux signaux selon l'une des revendications précédentes, dans lequel les traitements réalisés par la boucle de calcul de prédistorsion comprennent le sous-échantillonnage du signal émis, et où le deuxième décalage temporel est appliqué avant ledit sous-échantillonnage.

6. Dispositif de transmission d'un signal comprenant une boucle de calcul de prédistorsion (201) pour calculer des coefficients de prédistorsion numérique appliqués au signal à transmettre, et un amplificateur (103) pour amplifier et émettre ledit signal prédistordu, **caractérisé en ce qu'**il comprend :

- un moyen d'application (114) d'un premier décalage temporel à l'un des deux signaux utilisés par la boucle de calcul de prédistorsion, configuré pour compenser sensiblement l'écart temporel entre les deux signaux, les deux signaux utilisés par la boucle de calcul de prédistorsion étant :

• un premier signal correspondant au signal à transmettre avant ou après application de la prédistorsion,
• un deuxième signal correspondant au signal émis,
et

- un moyen d'application (202) d'un deuxième décalage temporel à l'un des deux signaux utilisés par la boucle de calcul de prédistorsion, configuré pour compenser sensiblement l'écart temporel entre les deux signaux après application du premier décalage temporel, le deuxième décalage temporel étant calculé à partir des coefficients de prédistorsion qui s'expriment linéairement en fonction du signal à transmettre.

**Patentansprüche**

1. Verfahren zur zeitlichen Synchronisierung zweier Signale in einer Signalübertragungsvorrichtung, wobei die beiden Signale von einer digitalen Vorverzerrungs-Berechnungsschleife (201) zur Berechnung von Vorverzerrungskoeffizienten (115) verwendet werden, die auf das zu übertragende Signal vor dessen Verstärkung (103) und Aussendung angewandt werden, wobei die beiden von der Vorverzerrungs-Berechnungsschleife verwendeten Signale Folgende sind:

- ein erstes Signal, das dem zu übertragenden Signal vor oder nach Anwendung der Vorverzerrung entspricht,
- ein zweites Signal, das dem ausgesendeten Signal entspricht, wobei das Verfahren **dadurch gekennzeichnet ist, dass** es nacheinander Folgendes umfasst:
- die Anwendung (601) auf eines der beiden Signale einer ersten Zeitverschiebung (114), die im Wesentlichen der Zeitabweichung zwischen den beiden Signalen entspricht, und
- die Anwendung (602) auf eines der beiden Signale einer zweiten Zeitverschiebung (202), die im Wesentlichen der Zeitabweichung zwischen den beiden Signalen nach Anwendung der ersten Zeitverschiebung entspricht, wobei die zweite Zeitverschiebung anhand der Vorverzerrungskoeffizienten berechnet wird, die linear als Funktion des zu übertragenden Signals ausgedrückt werden.

2. Verfahren zur zeitlichen Synchronisierung zweier Signale nach Anspruch 1, wobei die erste Zeitverschiebung eine theoretisch berechnete Verschiebung ist, die anhand eines Kalibrierungssignals gemessen oder durch Korrelation zwischen den beiden zeitlich zu synchronisierenden Signalen erzielt wird.

3. Verfahren zur zeitlichen Synchronisierung zweier Signale nach Anspruch 2, wobei die Vorverzerrungsschleife einen Generalised Memory Polynomial-Algorithmus implementiert, und wobei die zweite Zeitverschiebung $\Delta t$ Folgendes beträgt:

$$\Delta t = -Real\left[\frac{\sum_{l=0}^{L_a-1} l.\, a_{0,l}}{\sum_{l=0}^{L_a-1} a_{0,l}}\right],$$

wobei $a_{0,l}\,L_a$ Vorverzerrungskoeffizienten darstellt, die linear als Funktion des zu übertragenden Signals ausgedrückt werden, und *Real*(*X*)*den* Realteil der komplexen Zahl X.

4. Verfahren zur zeitlichen Synchronisierung zweier Signale nach Anspruch 2, wobei die Vorverzerrungsschleife einen Decomposed Vector Rotation-Algorithmus implementiert, und wobei die zweite Zeitverschiebung $\Delta t$ Folgendes beträgt:

$$\Delta_t = -Real\left[\frac{\sum_{l=0}^{M} l \cdot a_l}{\sum_{l=0}^{M} a_l}\right],$$

wobei $a_l$ M Vorverzerrungskoeffizienten darstellt, die linear als Funktion des zu übertragenden Signals ausgedrückt werden, und *Real*(*X*) den Realteil der komplexen Zahl X.

5. Verfahren zur zeitlichen Synchronisierung zweier Signale nach einem der vorhergehenden Ansprüche, wobei die durch die Vorverzerrungs-Berechnungsschleife ausgeführten Verarbeitungen die Unterabtastung des ausgesendeten Signals umfassen und wobei die zweite Zeitverschiebung vor der Unterabtastung angewendet wird.

6. Signalübertragungsvorrichtung, umfassend eine Vorverzerrungs-Berechnungsschleife (201) zum Berechnen digitaler Vorverzerrungskoeffizienten, die auf das zu übertragende Signal angewendet werden, und einen Verstärker (103) zum Verstärken und Aussenden des vorverzerrten Signals, **dadurch gekennzeichnet, dass** sie Folgendes umfasst:

- ein Mittel (114) zum Anwenden einer ersten Zeitverschiebung auf eines der beiden von der Vorverzerrungs-Berechnungsschleife verwendeten Signale, das so konfiguriert ist, dass es die Zeitabweichung zwischen den beiden Signalen im Wesentlichen kompensiert, wobei die beiden Signale, die von der Vorverzerrungs-Berechnungsschleife verwendet werden, Folgende sind:

 • ein erstes Signal, das dem zu übertragenden Signal vor oder nach Anwendung der Vorverzerrung entspricht,
 • ein zweites Signal, das dem ausgesendeten Signal entspricht,
 und

- ein Mittel (202) zum Anwenden einer zweiten Zeitverschiebung auf eines der beiden von der Vorverzerrungs-Berechnungsschleife verwendeten Signale, das konfiguriert ist, um im Wesentlichen die Zeitabweichung zwischen den beiden Signalen nach Anwendung der ersten Zeitverschiebung zu kompensieren, wobei die zweite Zeitverschiebung anhand der Vorverzerrungskoeffizienten berechnet wird, die linear als Funktion des zu übertragenden Signals ausgedrückt werden.

**Claims**

1. A method for temporally synchronising two signals in a signal transmission device, the two signals being used by a digital predistortion calculation loop (201) to calculate predistortion coefficients (115) applied to the signal to be transmitted before its amplification (103) and its emission, the two signals used by the predistortion calculation loop being:

- a first signal corresponding to the signal to be transmitted before or after application of the predistortion,
- a second signal corresponding to the emitted signal,

the method being **characterised in that** it comprises consecutively:

- the application (601), to one of the two signals, of a first time offset (114) corresponding substantially to the time gap between the two signals, and
- the application (602), to one of the two signals, of a second time offset (202) corresponding substantially to the time gap between the two signals after application of the first time offset, the second time offset being calculated on the basis of said predistortion coefficients which are expressed linearly as a function of the signal to be transmitted.

2. The method for temporally synchronising two signals according to claim 1, wherein the first time offset is an offset calculated theoretically, measured on the basis of a calibration signal, or obtained by correlation between the two signals to be temporally synchronised.

3. The method for temporally synchronising two signals according to claim 2, wherein the predistortion loop implements a Generalised Memory Polynomial algorithm, and where the second time offset $\Delta t$ equals:

$$\Delta t = -Real\left[\frac{\sum_{l=0}^{L_a-1} l.a_{0,l}}{\sum_{l=0}^{L_a-1} a_{0,l}}\right],$$

where $a_{0,l}$ represents $L_a$ predistortion coefficients which are expressed linearly as a function of the signal to be transmitted, and $Real(X)$ the real part of the complex number $X$.

4. The method for temporally synchronising two signals according to claim 2, wherein the predistortion loop implements a Decomposed Vector Rotation algorithm, and where the second time offset $\Delta t$ equals:

$$\Delta_t = -Real\left[\frac{\sum_{l=0}^{M} l \cdot a_l}{\sum_{l=0}^{M} a_l}\right],$$

where $a_l$ represents $M$ predistortion coefficients, which are expressed linearly as a function of the signal to be transmitted, and $Real(X)$ the real part of the complex number $X$.

5. The method for temporally synchronising two signals according to one of the preceding claims, wherein the processings carried out by the predistortion calculation loop comprise the downsampling of the signal emitted, and where the second time offset is applied before said downsampling.

6. A device for transmitting a signal comprising a predistortion calculation loop (201) for calculating digital predistortion coefficients applied to the signal to be transmitted, and an amplifier (103) for amplifying and emitting said predistorted signal, **characterised in that** it comprises:

- a means (114) for applying a first time offset to one of two signals used by the predistortion calculation loop, configured to substantially compensate the time gap between the two signals, the two signals used by the predistortion calculation loop being:

• a first signal corresponding to the signal to be transmitted before or after application of the predistortion,
• a second signal corresponding to the emitted signal,
and

- a means (202) for applying a second time offset to one of the two signals used by the predistortion calculation loop, configured to substantially compensate the time gap between the two signals after application of the first time offset, the second time offset being calculated on the basis of the predistortion coefficients which are expressed linearly as a function of the signal to be transmitted.

14

Etat de l'art

FIG.1a

EP 3 503 385 B1

Etat de l'art

FIG.1b

EP 3 503 385 B1

FIG.2

FIG.3a

FIG.3b

```
┌─────────────────────────────────┐
│                                 │ ⌒ 401
│  Application d'un premier décalage │
│            temporel              │
│                                 │
└─────────────────────────────────┘

┌─────────────────────────────────┐
│                                 │ ⌒ 402
│  Application d'un deuxième décalage │
│            temporel              │
│                                 │
└─────────────────────────────────┘
```

FIG.4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1331729 A1

- EP 2947833 A1

**Littérature non-brevet citée dans la description**

- **D.R. MORGAN ; Z. MA ; J. KIM ; M. G. ZIERDT ; J. PASTALAN.** A Generalized Memory Polynomial Model for Digital Predistortion of RF Power Amplifiers. *IEEE Transactions on Signal Processing,* Octobre 2006, vol. 54 (10), 3852-3860

- **A. ZHU.** Decomposed Vector Rotation-Based Behavioral Modeling for Digital Predistortion of RF Power Amplifiers. *IEEE Transactions on Microwave Theory and Techniques,* Février 2015, vol. 63 (2), 737-744